# EUROPEAN PATENT APPLICATION

(11) **EP 4 418 161 A1**
(43) Date of publication of application: **21.08.2024**
(21) Application number: 24154808.0
(22) Date of filing: 30.01.2024
(51) Int. Cl.: G06F 30/20, H01M 8/04298, H01M 8/10, H01M 8/04291

(54) **COMPUTER SIMULATION METHODOLOGY TO ANALYZE MASS, MOMENTUM, ENERGY AND CHARGE TRANSPORT IN A PROTON EXCHANGE MEMBRANE FUEL CELL**

(30) Priority: 01.02.2023 US 202318162764
(71) Applicant: Dassault Systemes Americas Corp., Waltham, MA 02451 (US)
(72) Inventor: Islam, Ashraful, Daly City (US); Otomo, Hiroshi, Lexington (US); Salazar-Tio, Rafael, San Ramon (US); Crouse, Bernd, Berkeley (US); Zhang, Raoyang, Burlington (US); Chen, Hudong, Newton (US)
(74) Representative: Bandpay & Greuter

(57) **Abstract**

A method analyzes physical transport in a proton exchange membrane fuel cell (PEMFC) having three adjacent layers L₁, L₂, L₃, each with a distinct porous structure. A first small scale multiphase simulation Si of a first portion of the L₁/L₂ interface is used to characterize the L₁/L₂ interface. The Si results are statistically extended to a larger second portion of the L₁/L₂ interface. The statistically extended L₁/L₂ interface is used as a boundary condition for a second multiphase simulation S₂ to characterize the L₂/L₃ interface. Si is repeated using the characterized L₂/L₃ interface as a boundary condition. S₁ and S₂ respectively simulate of one or more of momentum, energy, species, and charge transport across the L₁/L₂ and L₂/L₃ interface.

## Description

### FIELD OF THE INVENTION

The present invention relates to fuel cells, and more particularly, is related to simulating fluid flow through layer interfaces in a proton exchange membrane fuel cell.

### BACKGROUND

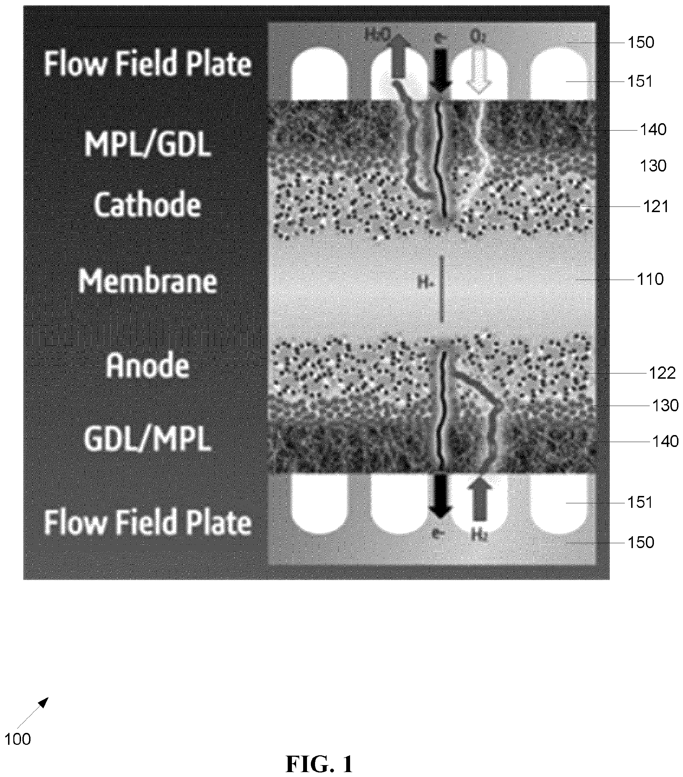

A typical PEMFC structure 100 is shown in FIG. 1, with nine layers. The inner most layer is a proton exchange membrane (PEM) 110 with a nanometer scale structure composed of polymer/water, and mainly responsible for proton diffusion. Above and below the PEM are the catalyst layers (CL) 121, 122, in particular, a cathode 121 and an anode 122 that respectively include hundreds of nanometer scale pore structure composed of graphite, platinum and ionomer where the redox reactions occur. Proceeding outwardly, the next layers are the micro-porous layers (MPL) 130 with a micrometer scale pore structure composed of graphite. The MPL layer helps to control the flow of gases and water. The next layers, the gas diffusion layers (GDL) 140 have tens of micrometer scale pore structure composed of hydrophobic carbon fibers and play the vital role of gas/water management flow. The outmost layers are the flow field plates 150 (or bipolar plates (BP)) where interconnected channels 151 of millimeter scale size provide the ultimate flow input and output for gases and water.

The analysis and simulation of how a Proton Exchange Membrane Fuel Cell (PEMFC) works is a challenging problem due to its complex multiscale, multi-physics nature. A PEMFC consists of functionally different microstructure layers where the length scale of the microstructures ranges from a few nanometers to a few millimeters. Direct numerical modeling attempts of such a system raises several issues. First, the resolution required to capture accurate physics in both fine (nm) and coarse (mm) scales is computationally resource intensive. Second, variations of length scale may invoke change of physics such as when a water droplet emerges from a micro-porous layer to a far wider gas channel, the droplet transitions from a capillary to inertia dominant physics of flow. Third, in a fuel cell like a PEMFC, these layers are also functionally coupled with each other, where mass, momentum, energy and charges are exchanged across the interface they share. Therefore, beyond accurately modeling the individual layers, a complete system analysis also involves capturing the physics at the layer interfaces.

The majority of previously published PEMFC work and inventions has been directed toward ex-situ treatment of the individual layers. Only a few have attempted to solve the problem comprehensively. The available work includes different variations of multiscale approach such as per U. S. Patent No. 7,627,460 B2 (Froning, D., Gubner, A., Poppinger, M. "Method for the modeling of material and/or heat exchange process in a device and device for carrying out said method"), where transport of more than one single phase fluids separated by solid has been described. The multiscale approach described in 7,627,460 does not model PEMFC multiphase fluid flow.

In another approach, as described by Jankovic, J., Zhang, S., Putz, A., Saha, M. S., Susac, D. ("Multiscale imaging and transport modeling for fuel cell electrodes" (Journal of Materials Research, 34(4), 579-591), different types of imaging were carried out to obtain 3D reconstructed microstructures of different layers in a PEMFC, and direct numerical simulations on 3D data sets with an upscaling approach was applied only to demonstrate the capability to simulate overall electrical conductivity of the system. However, Jankovic does not address more complex physics that occurs across PEMFC layers. Therefore, there is a need in the industry to address the abovementioned shortcomings.

### SUMMARY OF THE INVENTION

Embodiments of the present invention provide a computer simulation methodology to analyze mass, momentum, energy, and charge transport in proton exchange membrane fuel cell. Briefly described, the present invention is directed to a method analyzing physical transport in a proton exchange membrane fuel cell (PEMFC) having three adjacent layers L₁, L₂, L₃, each with a distinct porous structure. A first small scale multiphase simulation S₁ of a first portion of the L₁/L₂ interface is used to characterize the L₁/L₂ interface. The S₁ results are statistically extended to a larger second portion of the L₁/L₂ interface. The statistically extended L₁/L₂ interface is used as a boundary condition for a second multiphase simulation S₂ to characterize the L₂/L₃ interface. S₁ is repeated using the characterized L₂/L₃ interface as a boundary condition. S₁ and S₂ respectively simulate of one or more of momentum, energy, species, and charge transport across the L₁/L₂ and L₂/L₃ interface.

Other systems, methods and features of the present invention will be or become apparent to one having ordinary skill in the art upon examining the following drawings and detailed description. It is intended that all such additional systems, methods, and features be included in this description, be within the scope of the present invention and protected by the accompanying claims.

### BRIEF DESCRIPTION OF THE DRAWINGS

The patent or application file contains at least one drawing executed in color. Copies of this patent or patent application publication with color drawing(s) will be provided by the Office upon request and payment of the necessary fee.

The accompanying drawings are included to provide a further understanding of the invention, and are incorporated in and constitute a part of this specification. The components in the drawings are not necessarily to scale, emphasis instead being placed upon clearly illustrating the principles of the present invention. The drawings illustrate embodiments of the invention and, together with the description, serve to explain the principles of the invention.
FIG. 1 is a schematic diagram of a typical PEMFC structure, with nine layers.
FIG. 2 is a schematic diagram of first embodiment of a method for simulating general water management workflow in a PEMFC structure.
FIG. 3 is a schematic diagram of three layers of the PEMFC structure of FIG. 2.
FIG. 4 is a schematic diagram of a setup for a GDL and bipolar plate simulation.
FIG. 5 is a schematic diagram showing four different stages of water transport in the simulated setup of FIG. 4.
FIG. 6 is a series of plots showing the water breakthrough locations at different air pressure differences in the simulation setup of FIG. 4.
FIG. 7 is a plot showing water and air flux at the GDL/BP interface at several air pressure levels in the simulation setup of FIG. 4.
FIG. 8 is a series of diagrams demonstrating water breakthrough locations at a GDL/BP layer interface statistically extended to a larger surface area.
FIG. 9 is a diagram illustrating a simulated bipolar plate with the statistically extended GDL/BP interface where water is injected and air is expelled at specific locations.
FIG. 10 shows diagrams of simulated results of air and water flow in a bipolar plate, top view (top) and zoom-in picture (bottom). Color and iso-surface show the static pressure and water profiles.
FIG. 11 is a flowchart of an exemplary method for modeling water management in a fuel cell.
FIG. 12 is a schematic diagram illustrating an example of a system for executing functionality of the present invention.

### DETAILED DESCRIPTION

The following definitions are useful for interpreting terms applied to features of the embodiments disclosed herein, and are meant only to define elements within the disclosure.

As used within this disclosure, "proton-exchange membrane fuel cells" (PEMFC), also known as polymer electrolyte membrane (PEM) fuel cells, refer to a type of fuel cell typically used for transport applications, as well as for stationary fuel-cell applications and portable fuel-cell applications. They can operate in temperature and/or pressure ranges (50 to 100 °C) and a involve a proton-conducting polymer electrolyte membrane. PEMFCs generate electricity and operate on the opposite principle to PEM electrolysis, which consumes electricity. A PEMFC may be formed of membrane electrode assemblies (MEA) including electrodes, catalyst, and gas diffusion layers. The cell has a triple phase boundary (TPB) where the electrolyte, catalyst, and reactants mix.

As used within this disclosure, "membrane-electrode Assembly" (MEA), refers the PEM membrane and the cathode and anode catalyst layers of a PEMFC.

As used within this disclosure, "catalyst layer" (CL) refers to a nanometer scale pore structure of a PEMFC. The CL is added on both sides of the membrane-the anode layer on one side and the cathode layer on the other, immediately surround the PEM.

As used within this disclosure, "bipolar plate" (BP), or flow field plates refer to the exterior layer of a PEMFC to provide flow input and output for gases and water.

As used within this disclosure, "image quilting" refers to forming an image of a large surface by combining smaller images of portions of the surface.

As used within this disclosure, "statistical extension" refers to a method of applying the physical properties for a first portion of an interface to a second, larger portion of an interface, for example, via image quilting.

As used within this disclosure, the "Reynold's number" refers to a ratio of inertial forces to viscous forces within a fluid that is subjected to relative internal movement due to different fluid velocities. A region where these forces change behavior is known as a boundary layer.

As used within this disclosure, a "computational domain," or Computational Fluid Dynamics (CFD) domain, refers to a portion of space where the solution of a CFD simulation is calculated. The computational domain may be discretized into a computational grid (or mesh) to solve the discretized equations of fluid flows.

As used within this disclosure, a "computational grid" generally refers to a geometrically defined region of a fuel cell, typically at a layer interface and/or the layers at the interface, used for simulation in lieu of the entire layer interface.

As used within this specification, "species transport" generally refers to one or more chemical processes that occur in a bulk flow, at wall or particle surfaces, or in a porous zone of a fuel cell.

Reference will now be made in detail to embodiments of the present invention, examples of which are illustrated in the accompanying drawings. Wherever possible, the same reference numbers are used in the drawings and the description to refer to the same or like parts.

The exemplary embodiments are directed to addressing the difficulty in upscaling physics based microstructural simulations in a consistent way among multiple types of porous media, such as the layers in a PEMFC. The embodiments describe a generalized workflow, applicable to different physics such as mass, momentum, heat, and charge transfer across the different layers in a PEMFC, and in particular, provide a framework for physics analysis in a finer scale regarding the characterization of interfaces between different layers, the upscaling of an interface and the analysis of a larger scale model. This generalized workflow is described with regard to a water management simulation in the PEMFC, involving a micro-porous layer, a gas diffusion layer, and a bipolar plate.

Exemplary embodiments of the present invention are directed to improved fuel cell water management. A significant challenge associated with PEMFCs is the water balance in the fuel cell stack. Water is generated as the chemical reaction occurs in each cell. Depending upon the load and the operating conditions, there is a tendency for the fuel cells to flood or dry out. The water content in the polymer membrane affects the proton conductivity and affects activation overpotentials. If the MEA is not adequately humidified, the protonic conductivity decreases (the cell resistance increases).

Excess water can create an issue in fuel cells, preventing reactant diffusion to the catalyst sites by flooding of the electrodes, gas diffusion backings, or gas channels if the water removal is inefficient. For the membrane to remain hydrated, parameters such as current density, temperature, reactant flow rates, pressures, humidification, cell design, and component materials need to be balanced. Water in a PEM fuel cell arises due to the cathode reaction and the humidification of the reactant gases. The water production in the cathode depends upon the current density (the current being drawn by the load). Water buildup in a fuel cell can be mitigated through the gas diffusion layer, flow channel or heater design.

Practically, the exemplary embodiments are directed to a methodology that results in a change of design of the fuel cell, specifically, improving the design by choosing the optimal layers, microstructures, and combinations for a given operational range. While the embodiments are directed to the improvement of fuel cell water management, the workflow described in the embodiments may be general and applicable to other properties of interest for a fuel cell, such as heat propagation, mechanical integrity, electrical response and electrochemical simulation, alone, or in combination.

The exemplary embodiments provide discrete simulations of two fuel cell layers at a time, where one is simulated at a REV and a fraction of the other is captured. The result is a less computationally intensive approach than prior methods because the resolution of the simulations varies according to the properties (e.g., pore size) of the respective layers. The scale changes from layer to layer, eliminating the need of high resolution for the smaller layer by computing the effective interaction with the next larger layer. This benefit compounds as the scale increases from layer to layer.

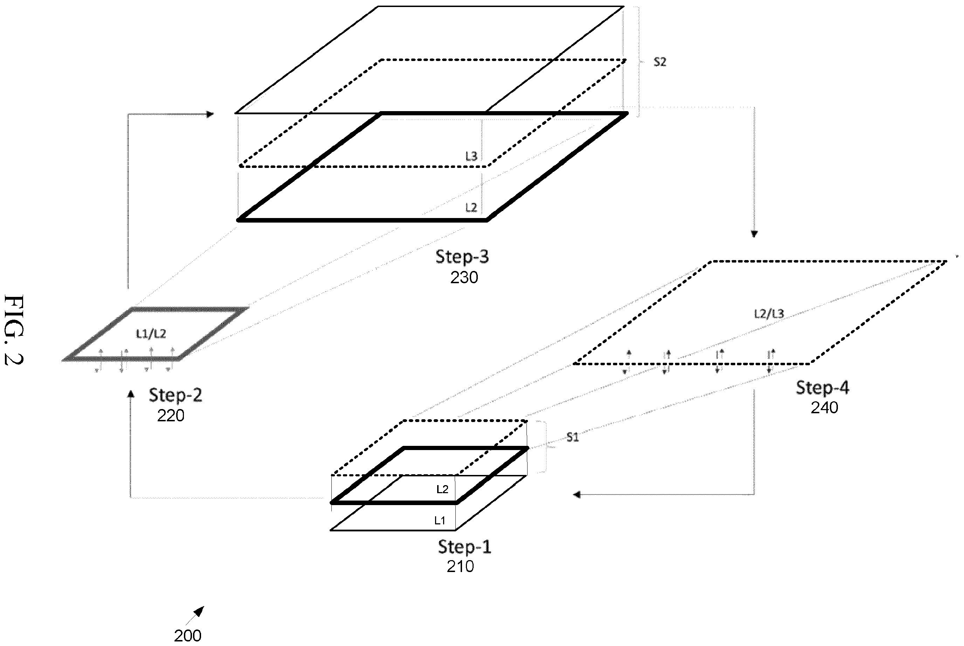

FIG. 2 illustrates a general simulation methodology 200 of the exemplary embodiments using only 3 layers of a PEMFC, namely L₁, L₂ and L₃, although the process is scalable to any number of layers. For example, L₁ may correspond to the catalyst layer (CL) 121, 122 (FIG. 1), L₂ may correspond to the MPL layer 130 (FIG. 1), and L₃ may correspond to the gas diffusion layers (GDL) 140 (FIG. 1). Alternatively, the layers L₁- L₃ of FIG. 2 may correspond to any three adjacent layers above or below the membrane 110 (FIG. 1).

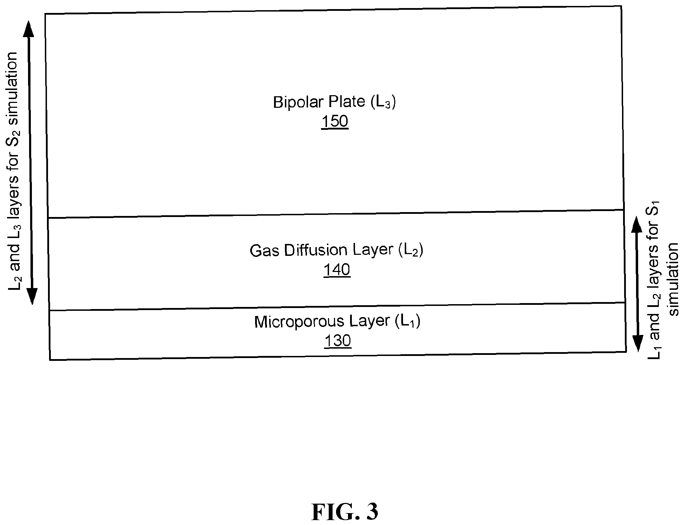

In a first step 210, mass, momentum, energy, species, and charge transported between two or more adjacent layers L₁, L₂ are computed in a first simulation S₁ using direct numerical simulation, where layers L₁ and L₂ are structurally different from each other. Here, the inner layer L₁ is closer to the proton exchange membrane 110 (FIG. 1) and contains finer structures than the outer layers L₂. The layers L₁, L₂, L₃ also play different roles in the energy and species transport across a fuel cell. The computational grid for simulation should be sufficiently resolved to accurately capture the physical phenomena in all the layers L₁, L₂, L₃. While in some instances the computational domain may cover only a fraction of the physical size of the fuel-cell stack, for example for the outer layer, in general the simulation domain for inner layer should be a representative elementary volume of that layer. In order to ensure this criteria, a multiscale approach (as outlined in *United States Patent Application Publication,* US2022/0207219 A1) may be used. Here, an initial estimation is made for the top and bottom boundary flux in the simulation of the first step 210. For consistency, the terms "top" and "bottom" are used to refer to the orientation of the layers shown in FIGS. 2 and 3, where L₃ is considered the top layer and L₁ is considered the bottom layer. It should be noted that "top" and "bottom" may not correspond to the orientation of an associated physical fuel cell.

In a second step 220, the energy and species exchange across the L₁/L₂ interface is analyzed for different operating conditions such as fluid pressure, flow rate, temperature, humidity, charge, species concentration, electric potentials etc. Optionally, more than one simulation S₁ may be performed at different locations of the fuel cell. L₁/L₂ interface properties used in the first simulation S₁ are statistically extended for use in a third step 230 to cover a larger interface area (for example, corresponding to larger pore sizes at the L₂/L₃ interface).

In a third step 230, a second simulation S₂ is performed including layers L₂ and L₃. In this case, the L₂ layer is larger than that of the first simulation S₁ with coarser resolution. As with the first simulation S₁, the grid resolution in the second simulation S₂ is sufficiently resolved for capturing the physical phenomena in L₂ and L₃.

In a fourth step 240, the second step 220 is repeated and the L₂/L₃ interface is characterized. A bottom boundary condition of the L₂/L₃ is obtained while an initial estimation is made for the top boundary flux. The initial condition estimation may be applied at the S2 simulation for the third step 230 for subsequent iterations.

The updated L₂/L₃ interface from Sz may then be used to perform a second S₁ simulation and recalibrate the L₁/L₂ interface. The results from S₁ can in turn be used to provide more accurate boundary condition at the S₂ simulation. In particular, the top boundary condition used in the first S₁ simulation is replaced by the bottom boundary condition from the fourth step 240 to be used in a second iteration of the first step 210. Thus S₁/S₂ simulations maybe iteratively continued until property exchanges are converged at the L₁/L₂ and L₂/L₃ interfaces.

The workflow proceeds with a series of simulations up to S_{N}, involving N+1 layers where the sync simulations are conducted between Sᵢ and S₍ᵢ₋₁₎. The final upscaled simulation, S_{N}, provides a comprehensive energy and species exchange information for the entire system. The steps of FIG. 2 as outlined above are described in detail below.

A physical PEMFC may be formed according to the L₁/L₂ and L₂/L₃ interfaces as characterized by the S₁ and S₂ simulations. For example, the physical PEMFC may be formed based on simulated layer characteristics and/or conditions for a specific implementation environment and/or application for the physical PEMFC.

FIG. 2 depicts the modeled layer surfaces as diamonds. Instead of modeling/simulating the entire interface surface area between adjacent layers, the embodiments model small portions of the interface surface. Modeling a smaller interface area is less computationally intensive than modeling a larger interface area. The size of the smaller interface area to be modeled may be determined according to the physical attributes of the layers, as well as the physical property being modeled. For example, since the embodiments are directed to water management, the statistical area to be modeled may be proportional to the pore sizes of the layers at the interface with respect to water fluid dynamics. For the example shown in FIG. 2, the pore sizes at the modeled interface area between the first and second layers are smaller than the pore sizes at the modeled interface area between the second and third layers, hence the modeled area of the first step 210 and the second step 220 are depicted with smaller diamonds than the third step 230 and the fourth step 240. The statistical extension of the MPL/GDL interface (described further below) of the first step 210 and second step 220 to a larger interface modeled third step 230 and fourth step 240 is indicated by the change from a smaller L₁/L₂ diamond in the second step 220 to a larger L₂ diamond in the third step 230. It should be noted that in other examples, the relative pore sizes of the simulated layers may be different from those described in FIG. 2.

While FIG. 2 describes a general framework for the present invention, FIGS. 3-11 are directed an embodiment having three specific layers of a fuel cell namely the microporous layer 130, the gas diffusion layer 140, and the bipolar plate 150 (FIG. 3). However, the scope of the present invention is not limited to three layers, and alternative embodiments may be directed to more than three layers, and/or to different fuel cell layers.

Water is produced in the cathode catalyst layer (CL) 121 (FIG. 1) of an operating PEMFC 100 as a result of a reduction reaction in presence of oxygen fuel. A fraction of the water produced is used to keep the proton exchange membrane 110 hydrated, and the rest is removed through the gas diffusion layer (GDL) 140 and adjacent bipolar plate (BP) 150. The challenge of water management is to avoid a "dry-out" of the membrane 110 at low current density and to prevent water-flooding of the GDL 140 at high current density.

The GDL 140 is typically made of carbon paper that is typically a few hundred micrometers thick with a 70% to 80% porosity. The GDL 140 has hydrophobic Poly-Tetra-Fluoro-Ethylene (PTFE) coated fibers that are 5~10 µm in diameter. The GDL 140 facilitates reactant gas transport to the catalyst layer 121/122, and at the same time creates water breakthrough pathways to the bipolar plate 150. The GDL 140 is typically coated with a thin microporous layer (MPL) 130, usually on the order 50~70 µm thick, consisting mainly of carbon powder and PTFE binders. The MPL 130 helps water management in the fuel cell 100 by stabilizing the water breakthrough pathways in the GDL 140, which helps reduce water saturation in the GDL 140 and creates electric contact between the GDL 140 and CL 121, 122.

When water and/or air capillary pressure is increased inside the GDL 140, the water front advances non-linearly, which may be characterized by the Haines jump. Porous media, such as GDL, may be characterized by the bottle-neck radius, which is the radius of largest rigid sphere that can be pushed across the fluid percolation direction of the media. The water front fills the larger pores first, halts at the bottle-neck to reach capillary pressure dictated by the pore-throat structure, and then rushes through the pore space that can be intruded at current pressure. The water front makes another jump when capillary pressure increases further. As a result, water percolates through the hydrophobic GDL microstructure (non-wetting pore space) by creating capillary fingers, and finally emerges to the bipolar plate 150.

The bipolar plate 150 includes hydrophilic channels 151 to collect the water that emerges from the GDL 140. Depending on the air and water flow in the bipolar plate 150, various water flow patterns may be observed in the bipolar plate 150, for example, slug flow, film flow and mist flow.

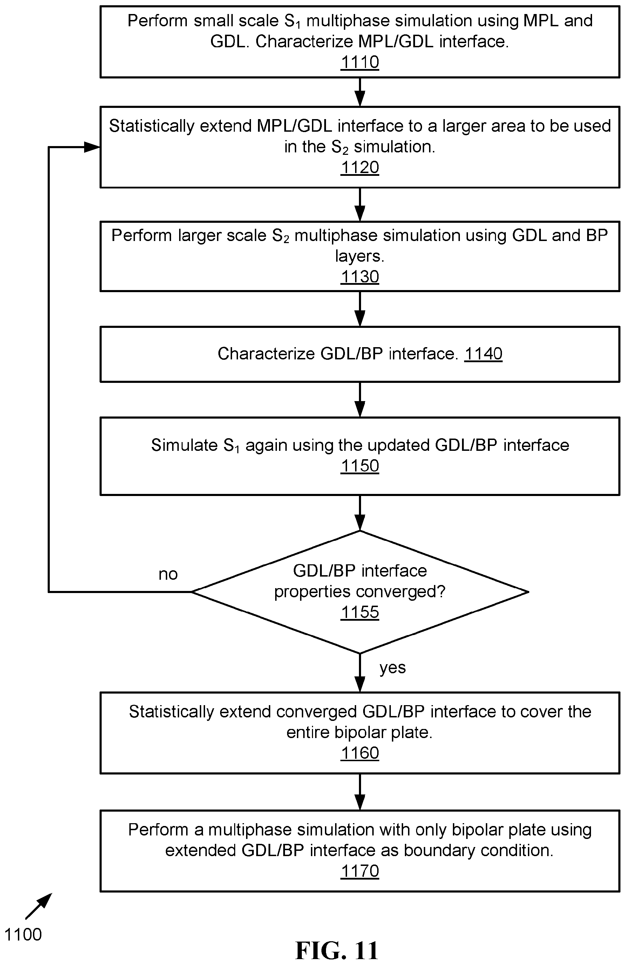

FIG. 11 is a flowchart of an exemplary method for modeling water management in a fuel cell. Here, the workflow of FIG. 2 outlined in the previous section is applied to simulate water management through a microporous plate, a gas diffusion layer and a bipolar plate. When compared to the general workflow described above, the microporous layer (MPL) 130, the gas diffusion layer (GDL) 140 and bipolar plate (BP) 150 can be viewed as the *L*₁, *L*₂ and *L*₃ layers of FIG. 2, respectively. The MPL (*L*₁) and BP (*L*₂) layers are considered in the *S*₁ simulation, while *S*₂ simulation involves the GDL(*L*₂) and BP(*L*₃) as shown in FIG. 3.

It should be noted that any process descriptions or blocks in flowcharts should be understood as representing modules, segments, portions of code, or steps that include one or more instructions for implementing specific logical functions in the process, and alternative implementations are included within the scope of the present invention in which functions may be executed out of order from that shown or discussed, including substantially concurrently or in reverse order, depending on the functionality involved, as would be understood by those reasonably skilled in the art of the present invention.
A small scale first multiphase simulation (*S*₁) is performed using the MPL 140 and GDL 130, as shown by block 1110. A 3D modeled microstructure of the MPL 140 and GDL 130 is created from x-ray micro-tomography 3D scanned images. The procedure to create 3D modeled microstructure from the scanned images is described, for example, in G.R. Jerauld, J. Fredrich, N. Lane, Q. Sheng, B. Crouse, D.M. Freed, A. Fager, and R. Xu, "Validation of a workflow for digitally measuring relative permeability," SPE 188688, SPE Abu Dhabi Int. Pet. Exhib. & Conf, Abu Dhabi, U.A.E., Nov., 2017*.* Here, the MPL 140 (which has a finer pore structure than the GDL 130) is captured at a representative elementary volume (REV) and enough resolution for its critical pore throat, while the modeled GDL may not represent REV at the S₁ simulation but capture some minimal solid and pore structures at the interface. The resolution for the S₁ simulation is selected to be sufficient to capture accurate physics in both the GDL 130 and the MPL 140 according to the applicable properties being simulated. For example, the resolution for the S₁ simulation for water management through GDL and MPL may be 1 µm/pixel, according to the corresponding 20 µm bottleneck radius for the GDL 130 and 2 µm for the MPL 140.

In an operating fuel cell, water is supplied at a specific volumetric injection rate from the bottom boundary of the MPL layer while air is expelled at a specific rate from the same boundary. The water injection volume may be a function of outgoing mass flux on the bottom surface as governed by the oxidation reaction in the cathode layer. The MPL 140 shares a common interface with the GDL 130. A constant air pressure is set to the GDL top boundary. Both air and water can pass through this boundary. Impervious solid walls are placed along the front, back, left, and right boundaries.

The MPL 140 has finer pore space than the GDL 150 with hydrophobic coating. As a result, capillary entry pressure is also higher for the water to penetrate MPL 140. However, the MPL 140 often contains cracks/defects, for example, introduced either during manufacturing of carbon paper or assembly of fuel cell stack. As a result, water can intrude MPL 140 at a lower pressure through these cracks. The cracks may also help create preferential water pathways into the GDL 130.

Air flows in the opposite direction to the flow of water from the top GDL boundary to the bottom MPL boundary. The simulation is continued up until the water and air saturation has converged for the entire domain and in each layer separately. Afterwards, water injection and air expel rates are updated at the MPL bottom boundary and the S₁ simulation is performed again. For each exchange rate, the following properties are recorded at the MPL/GDL interface:
1. Water breakthrough location
2. Pressure distribution
3. Air and water flow rate

The MPL/GDL interface is statistically extended to a larger area to be used in the S₂ simulation, as shown by block 1120. Here, the statistical interface reconstruction is conducted for the MPL/GDL interface. During the reconstruction, the properties calculated such as water breakthrough locations, pressure distribution and air/water flow rate are statistically extended from the smaller area used in the S₁ simulation to cover a larger area to be used in the S₂ simulation. As a non-limiting example, the interface area used for the S1 simulation may be on the order of thousands of µm², and the interface area used for the S2 simulation may be on the order of hundreds of thousands of µm².

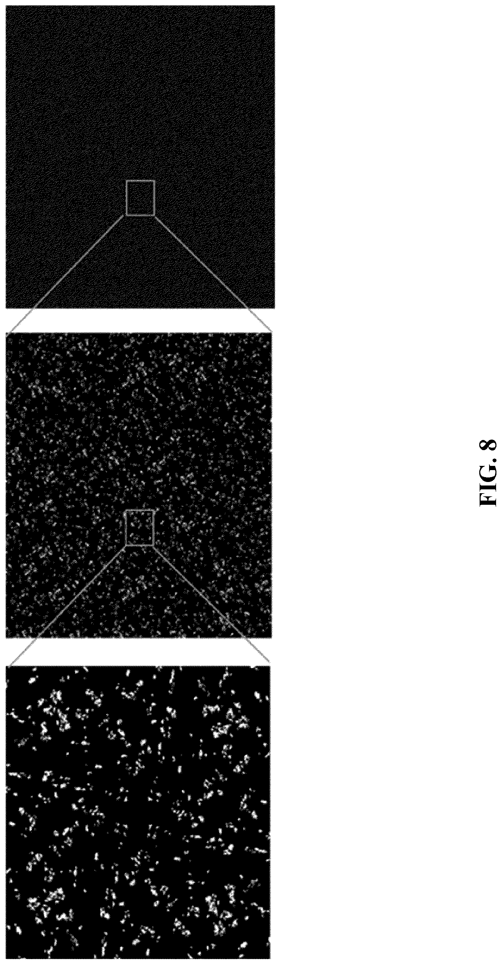

FIG. 8 shows three levels application of image quilting (see Efros, A., Freeman, W. (2001). Image Quilting for Texture Synthesis and Transfer. Proceedings of SIGGRAPH '01, Los Angeles, California, August 2001), which is one of several statistical methods that may be used to generate a larger image based on a training image. For example, in a quilting process a sequence of patches that are consistent in an overlapping boundary region are randomly selected. In order to include more patterns in the training image, three rotations of a given image may be considered and stitched together. Once the new large image is created by quilting, a coarsening process is continued by averaging down the image, in a coarsening process by a factor 3 for instance, every 3x3 set of local pixels is replaced by the average value of the 9 pixels. The resulting coarsen image can be used as a training image for subsequent statistical reconstruction iterations.

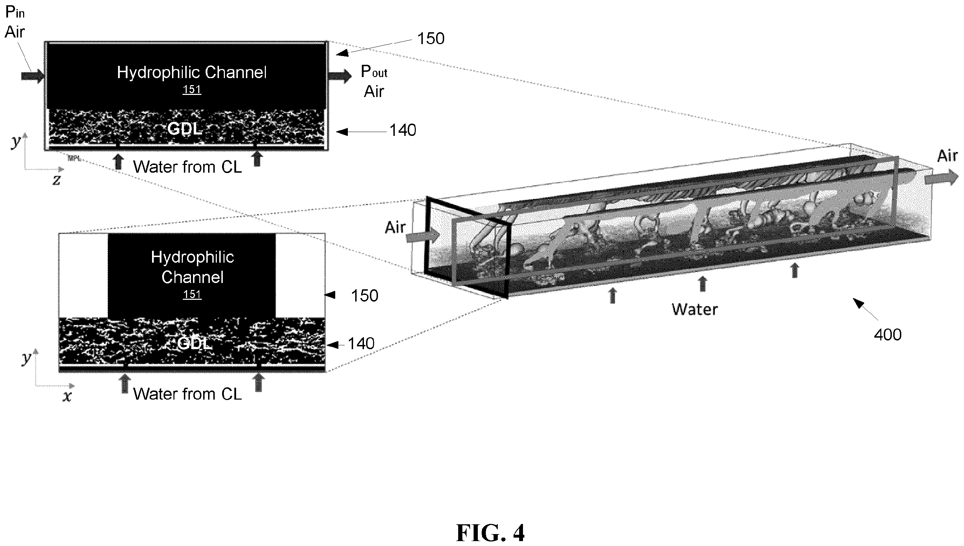

A larger scale S₂ multiphase simulation is performed using the GDL 140 and the BP 150 layer, as shown by block 1130. Water transport through the air filled GDL 140 and bipolar plate 150 is captured in a second direct simulation (S₂), for example, using a multiphase Lattice Boltzmann method. The resolution is set to be sufficient to capture the physics of flow in both the GDL and BP channels (at least one channel). However, in order to be within limits of available computational resources, only a small fraction of the bipolar plate 150 (at least one channel) may be simulated while a representative elementary volume is chosen for the GDL 140. FIG. 4 shows a 3D diagram of an interface 400 of a BP layer 150 single channel oriented above an adjacent GDL 140, with cross-sectional view parallel to (upper left) and perpendicular to (lower left) a hydrophilic channel 151 in the BP layer 150. As shown by FIG. 4, the rectangular bipolar plate 150 sits atop the GDL 140. Hydrophilic channels 151 in the bipolar plate 150 are open to the air flow from left to right (right hand image) and water can enter into hydrophilic channel 151 from the GDL 140 below. The top left image is parallel to the air flow direction through the hydrophilic channel, while the bottom left image is perpendicular to the air flow direction.

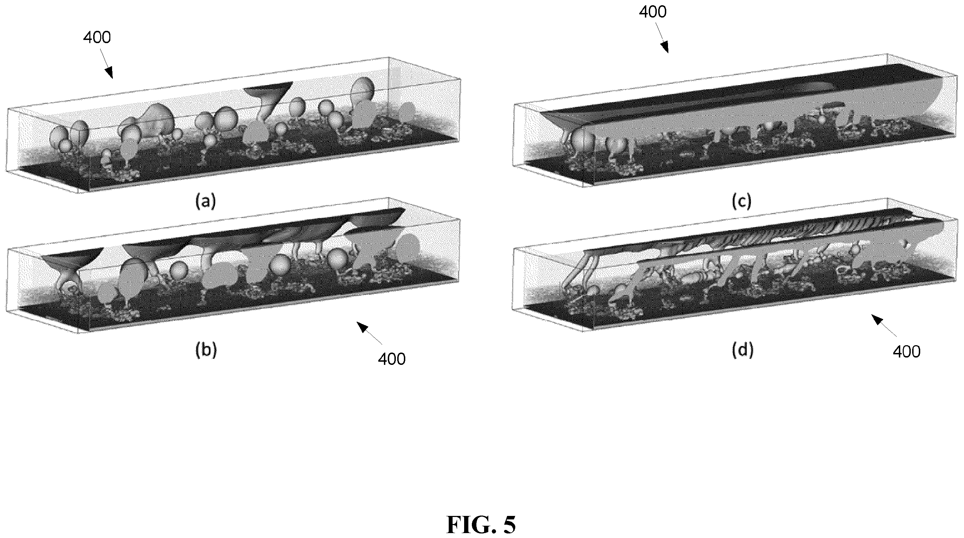

The extended MPL/GDL interface (as per block 1120) is used to set up the bottom boundary condition of the GDL 140. The GDL/BP interface contains a spatial distribution of water breaking through from the GDL 140 to the BP layer 150 at points, and a volumetric (both air and water) flow rate. A pressure differential is applied across the bipolar plate 150 to drive the air flow through the hydrophilic channels 151. At the beginning of the simulation, the air pressure is kept small, allowing the water to form droplets at the GDL/BP interface, as shown by FIG. 5(a). These droplets come into contact with the hydrophilic bipolar plate wall as they grow bigger and eventually form water slugs by merging with each other, as shown by FIG. 5(b). The slug grows as more water is injected into the system and forms a water bridge that spans over opposite walls in the bipolar plate 150, as shown by FIG. 5(c). The simulation continues at a low air pressure until water saturation in the whole domain is no longer changing. Afterwards, the air pressure is increased, resulting in the water slug dispersing and creating a water film on both walls of the hydrophilic channels 151, as shown by FIG. 5(d). Tributary water streams originate from the near-wall breakthrough locations that feeds into the mainstream water film. The breakthrough sites located apart from the wall produce water droplets repeatedly that are quickly snapped off and carried downstream by the air flow. As a result, in addition to the film flow, water is also transported by creating mist flow in the bipolar plate 150.

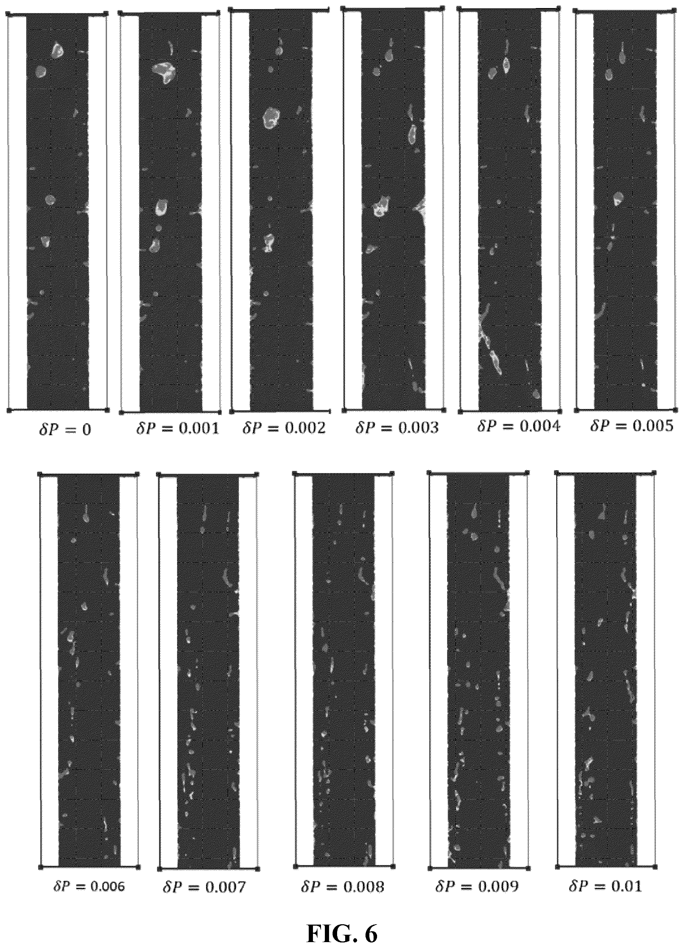

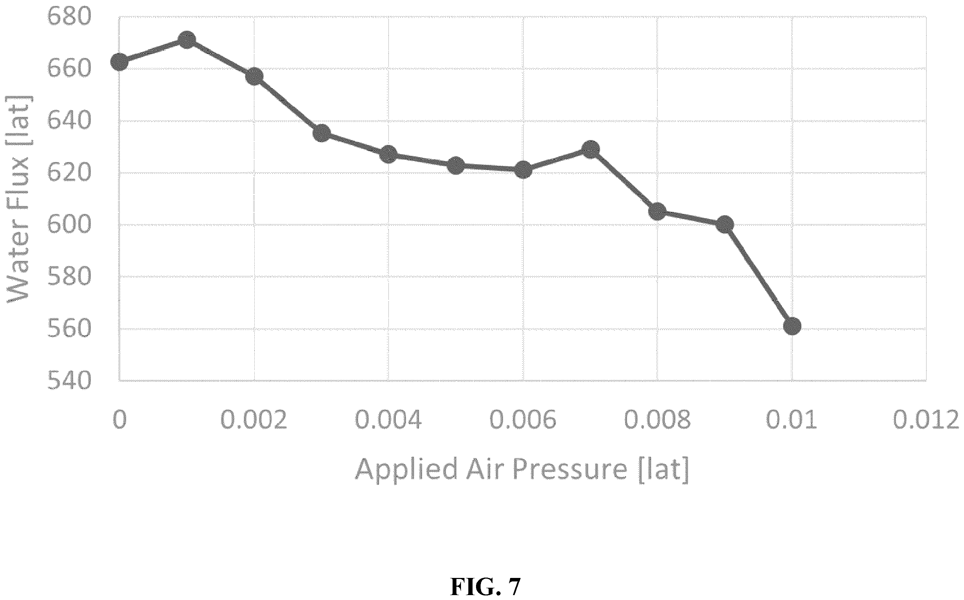

The GDL/BP layer interface is characterized, as shown by block 1140. Once the S₂ simulation is completed as per block 1130, water breakthrough locations on the GDL/BP interface are identified. FIG. 6 shows the water breakthrough locations (in red) at different air pressure differences. FIG. 7 is a plot of water and air flux at the GDL/BP interface at several air pressure levels.

The GDLBP interface characterization from the S₂ simulation is used in a second iteration of the S₁ simulation, as shown by block 1150. Previously, the top boundary condition in the S₁ simulation was set to a constant air pressure while water is injected and air is expelled at a constant rate at the bottom boundary. Here, the S₁ simulation is repeated again, but this time the initial top boundary condition is replaced with the top boundary condition obtained from the second simulation of block 1130. In particular, the water and air flux is measured as different levels of air pressure is applied as the top boundary condition while the bottom boundary is set to a constant water pressure that allows both the air and water to pass through freely.

As shown by block 1155, the MPL/GDL and GDL/BP interface properties are compared between the present and previous successive iterations. If the comparison does not satisfy a predetermined convergence criteria, such as water breakthrough location, water and air flux, the processing reverts to blocks 1120-1150 for a further S₁/S₂ iteration. If the comparison at block 1155 satisfies the convergence criteria, the method proceeds to block 1160.

The converged GDL/BP interface is statistically extended to cover the entire bipolar plate 150, as shown by block 1160. The characteristic properties such as water breakthrough locations and water flux calculated at the converged GDL/BP interface is statistically extended to a larger surface area. The statistical interface reconstruction is conducted for each different air pressure simulated in the S₂ simulation (as per block 1130). FIG. 8 shows three levels of application of image quilting (see Efros, A., Freeman, W. (2001). Image Quilting for Texture Synthesis and Transfer. Proceedings of SIGGRAPH '01, Los Angeles, California, August 2001), which is one of the possible statistical methods to generate a larger image based on a training image. As described previously, the quilting process may include stitching together a randomly selected sequence of patches that are consistent in some overlapping boundary region, including rotations of a given image. Once the new large image is created by quilting, a coarsening process is continued by averaging down the image, in a coarsening process by a factor 3 for instance, every 3x3 set of local pixels is replaced by the average value of the 9 pixels. The new large image may be re-used as a training image. For example, this process may be used to scale from 3µm to 30 µm and finally 300 µm per pixel, by applying a x10 coarsening factor twice, as illustrated in FIG. 8.

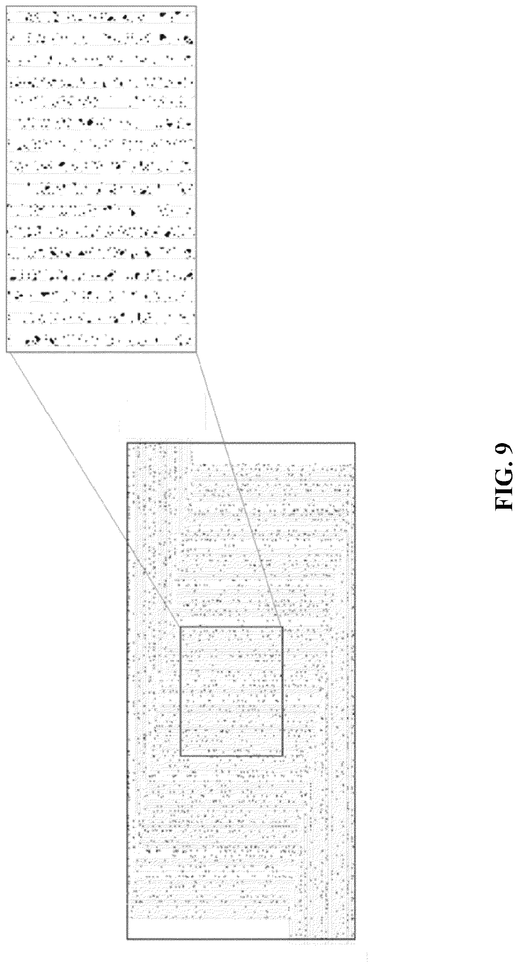

A multiphase simulation is performed with the bipolar plate using only the extended GDLIBP interface as a boundary condition, as shown by block 1170. Here, air and water flow in the bipolar plate (BP) is simulated using the statistically extended GDL/BP interface discussed in previously as the boundary condition. Specifically, using the data captured in the GDL simulation, water is injected (also, air is expelled) at specific locations by the desired amount. An example pattern of the injected water is shown in FIG. 9.

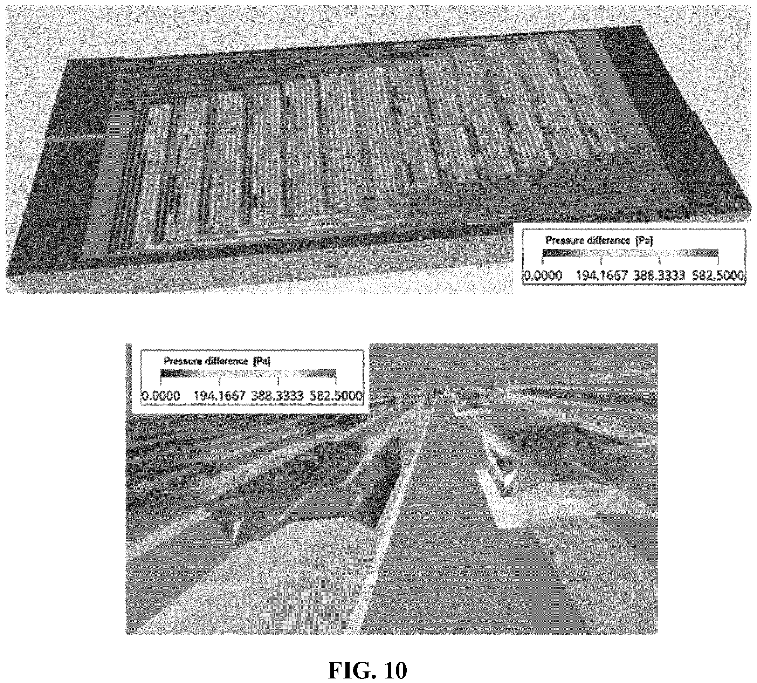

Air flow is primarily driven by the pressure difference between the inlet and outlet, which are shown at the right-top corner and left-bottom corner in FIG. 9. To evaluate the drainage efficiency of the bipolar plate channels, the pressure difference is gradually increased and the critical pressure, which allows most of water to be removed from the channel, is estimated. In FIG.10, the simulated results are shown using the color contour of the pressure and iso-surface of the water profile. The top figure shows the capillary pressure against the pressure difference between the inlet and outlet. The bottom figure shows the detailed pattern of the water slugs, which attach to the hydrophilic channel top wall and detach from the hydrophobic GDL bottom side.

The above described embodiments may be implemented by a practical application for designing a physical fuel cell using specific materials and physical constraints, and having specific functional performance characteristics under conditions for a given application. This streamlines and improves the design and manufacturing process, in particular, reducing the number of design/build/test iterations to optimize a fuel cell for a given application.

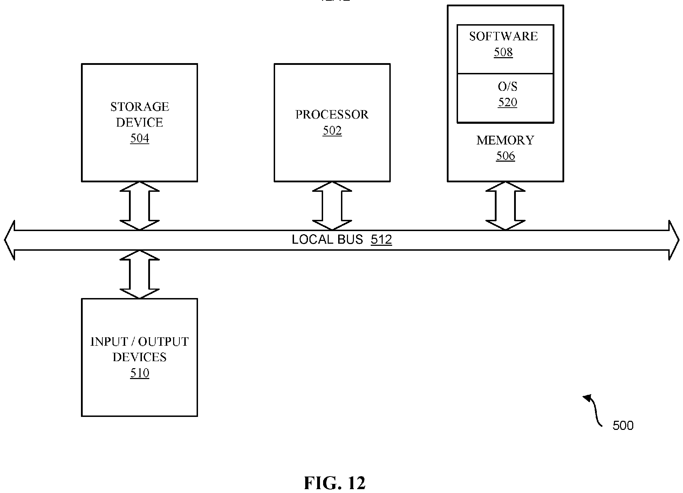

As previously mentioned, the present system for executing the functionality described in detail above may be a computer, an example of which is shown in the schematic diagram of FIG. 12. The system 500 contains a processor 502, a storage device 504, a memory 506 having software 508 stored therein that defines the abovementioned functionality, input, and output (I/O) devices 510 (or peripherals), and a local bus, or local interface 512 allowing for communication within the system 500. The local interface 512 can be, for example but not limited to, one or more buses or other wired or wireless connections, as is known in the art. The local interface 512 may have additional elements, which are omitted for simplicity, such as controllers, buffers (caches), drivers, repeaters, and receivers, to enable communications. Further, the local interface 512 may include address, control, and/or data connections to enable appropriate communications among the aforementioned components.

The processor 502 is a hardware device for executing software, particularly that stored in the memory 506. The processor 502 can be any custom made or commercially available single core or multi-core processor, a central processing unit (CPU), an auxiliary processor among several processors associated with the present system 500, a semiconductor based microprocessor (in the form of a microchip or chip set), a macroprocessor, or generally any device for executing software instructions.

The memory 506 can include any one or combination of volatile memory elements (e.g., random access memory (RAM, such as DRAM, SRAM, SDRAM, *etc.*)) and nonvolatile memory elements (*e.g*., ROM, hard drive, tape, CDROM, *etc.*)*.* Moreover, the memory 506 may incorporate electronic, magnetic, optical, and/or other types of storage media. Note that the memory 506 can have a distributed architecture, where various components are situated remotely from one another, but can be accessed by the processor 502.

The software 508 defines functionality performed by the system 500, in accordance with the present invention. The software 508 in the memory 506 may include one or more separate programs, each of which contains an ordered listing of executable instructions for implementing logical functions of the system 500, as described below. The memory 506 may contain an operating system (O/S) 520. The operating system essentially controls the execution of programs within the system 500 and provides scheduling, input-output control, file and data management, memory management, and communication control and related services.

The I/O devices 510 may include input devices, for example but not limited to, a keyboard, mouse, scanner, microphone, *etc.* Furthermore, the I/O devices 510 may also include output devices, for example but not limited to, a printer, display, *etc.* Finally, the I/O devices 510 may further include devices that communicate via both inputs and outputs, for instance but not limited to, a modulator/demodulator (modem; for accessing another device, system, or network), a radio frequency (RF) or other transceiver, a telephonic interface, a bridge, a router, or other device.

When the system 500 is in operation, the processor 502 is configured to execute the software 508 stored within the memory 506, to communicate data to and from the memory 506, and to generally control operations of the system 500 pursuant to the software 508, as explained above.

When the functionality of the system 500 is in operation, the processor 502 is configured to execute the software 508 stored within the memory 506, to communicate data to and from the memory 506, and to generally control operations of the system 500 pursuant to the software 508. The operating system 520 is read by the processor 502, perhaps buffered within the processor 502, and then executed.

When the system 500 is implemented in software 508, it should be noted that instructions for implementing the system 500 can be stored on any computer-readable medium for use by or in connection with any computer-related device, system, or method. Such a computer-readable medium may, in some embodiments, correspond to either or both the memory 506 or the storage device 504. In the context of this document, a computer-readable medium is an electronic, magnetic, optical, or other physical device or means that can contain or store a computer program for use by or in connection with a computer-related device, system, or method. Instructions for implementing the system can be embodied in any computer-readable medium for use by or in connection with the processor or other such instruction execution system, apparatus, or device. Although the processor 502 has been mentioned by way of example, such instruction execution system, apparatus, or device may, in some embodiments, be any computer-based system, processor-containing system, or other system that can fetch the instructions from the instruction execution system, apparatus, or device and execute the instructions. In the context of this document, a "computer-readable medium" can be any means that can store, communicate, propagate, or transport the program for use by or in connection with the processor or other such instruction execution system, apparatus, or device.

Such a computer-readable medium can be, for example but not limited to, an electronic, magnetic, optical, electromagnetic, infrared, or semiconductor system, apparatus, device, or propagation medium. More specific examples (a nonexhaustive list) of the computer-readable medium would include the following: an electrical connection (electronic) having one or more wires, a portable computer diskette (magnetic), a random access memory (RAM) (electronic), a read-only memory (ROM) (electronic), an erasable programmable read-only memory (EPROM, EEPROM, or Flash memory) (electronic), an optical fiber (optical), and a portable compact disc read-only memory (CDROM) (optical). Note that the computer-readable medium could even be paper or another suitable medium upon which the program is printed, as the program can be electronically captured, via for instance optical scanning of the paper or other medium, then compiled, interpreted, or otherwise processed in a suitable manner if necessary, and then stored in a computer memory.

In an alternative embodiment, where the system 500 is implemented in hardware, the system 500 can be implemented with any or a combination of the following technologies, which are each well known in the art: a discrete logic circuit(s) having logic gates for implementing logic functions upon data signals, an application specific integrated circuit (ASIC) having appropriate combinational logic gates, a programmable gate array(s) (PGA), a field programmable gate array (FPGA), etc.

The above described embodiments relate to the modeling and simulation of a physical fuel cell as part of the process of construction and testing of the physical fuel cell. In particular, the simulation allows designers of a fuel cell to model a physical fuel cell and to simulate the performance of various aspects of the physical fuel cell within a computer environment.

Numerical simulation of water transport through the GDL 140 and the bipolar plate 150 can be challenging as the transport spans over multiple length scales. In order to accurately capture the capillary events in a micro porous GDL 140, the pore space of the GDL 140 must be sufficiently resolved. The GDL 140 exchanges mass and momentum with the bipolar plate 150, so GDLIBP interactions need to be captured concurrently for accurate modeling. Here again, the simulated BP channel has a simplified geometric structure, but the channel needs to be long enough to capture various fluid flow pattern. However, extension to the fine resolution GDL 140 throughout the long bipolar plate is very computationally expensive. Neither a co-simulation approach nor a variable resolution simulation domain can be efficient in this regard, as both require the fine resolution GDL 140 to accompany the long bipolar plate 150. The above described embodiments address this problem by reducing the computational cost required for analyzing the whole fuel cell stack 100 (FIG. 1).

In addition to the computational cost, capturing the GDL/BP interface can be challenging. Once a water droplet is snapped off in the bipolar plate air stream, the air-water capillary pressure can decrease and may lead to capillary fragmentation of a continuous water path inside GDL 140. The physics of this capillary fragmentation can be very similar to the roof snap-off phenomena where both lateral and radial curvature of the air-water interface determines snap-off. Subsequently, when water pressure builds up again, another preferential water path with separate water breakthrough location on the GDL/BP interface may appear. As a result, the water breakthrough location may change over the time. In addition, the breakthrough locations and water drainage rate may vary with the air flow rate in the bipolar plate 150. Thus, depending on the flow conditions of both GDL 140 and bipolar plate 150, the GDLBP interface demonstrates a dynamic behavior. Previously, this led to problems simulation approaches where only GDL or bipolar plate is simulated assuming a static interaction with the other layers. The workflow described here dynamically characterizes the interface between different layers of the PEMFC structure 100 for various operating conditions and successfully addresses this problem.

Another challenge simulating the PEMFC structure 100 is multi-physics in nature, as the physics of fluids is quite different between GDL 140 and bipolar plate 150. The typical Reynold's number in the GDL 140 is less than unity whereas Reynold's number in the bipolar plate 150 can be as high as 2000, depending on the air flow rate and dimension of the channel. Here again, water transport through porous the GDL 140 is a capillary dominant flow where the typical capillary number (Reynolds number) ranges from 10⁻⁸ to 10⁻⁵. As a result, when a water droplet is drained to bipolar plate 150, the flow transitions from capillary dominant flow to a viscosity/inertia dominant flow field. Depending on the fluid flow simulation methodology and its limitations, one or more methods may be more suitable for a particular physics of fluids. But the challenge arises as these different physics of fluids are coupled within an operating fuel cell stack. The exemplary embodiments address this problem by choosing the appropriate physics for different layers and combining them together by the shared interface characterization.

It will be apparent to those skilled in the art that various modifications and variations can be made to the structure of the present invention without departing from the scope or spirit of the invention. In view of the foregoing, it is intended that the present invention cover modifications and variations of this invention provided they fall within the scope of the following claims and their equivalents.

## Claims

1. A computer based method to analyze mass, momentum, energy and charge transport in a proton exchange membrane fuel cell (PEMFC) via a computer simulation of the PEMFC to address water management in a physical PEMFC comprising a plurality adjacent layers comprising a first layer L₁, a third layer L₃, and a second layer L₂ disposed between the first layer L₁ and the third layer L₃, a first interface L₁/L₂ between L₁ and L₂, a second interface L₂/L₃ between L₂ and L₃, each layer comprising a material having a porosity scale or non-porous structure distinct from each adjacent layer, the method comprising the steps of:
performing a first small scale multiphase simulation S₁ of the first interface for a first portion of the first interface;
characterizing the first interface after the first small scale multiphase simulation S₁;
statistically extending S₁ results for the first interface to a second portion of the first interface with a larger area that the first portion;
performing a second multiphase simulation S₂ for the second interface using the statistically extended first interface as **characterized by** the first small scale multiphase simulation S₁ as a boundary condition;
characterizing the second interface after the second small scale multiphase simulation S₂; and
repeating the first small scale multiphase simulation S₁ using the second interface **characterized by** the second small scale multiphase simulation S₂ as a boundary condition,
wherein the multiphase simulations S₁ and S₂ each comprise simulation of one or more of the group consisting of momentum, energy, species, and charge transport across the interface between the simulated layers L₁/L₂ and L₂/L₃, respectively.

2. The method of claim 1, further comprising the step of iterating the S₁ and S₂ simulations until the first interface characterization has converged according to a predetermined convergence criteria.

3. The method of claim 1, wherein the second multiphase simulation S₂ is a larger scale simulation than the S₁ simulation.

4. The method of claim 2, wherein the third layer L₃ comprises a bipolar plate (BP) formed of a non-porous material further comprising a channel configured to convey gas and/or fluid.

5. The method of claim 4, further comprising the step of statistically extending the converged second interface to cover the entire bipolar plate.

6. The method of claim 4, wherein the second layer L₂ comprises a gas diffusion layers (GDL), and the second interface L₂/L₃ comprises a GDLIBP interface.

7. The method of claim 6, further comprising the step of performing a multiphase simulation with only the bipolar plate using extended GDLIBP interface as boundary condition.

8. The method of claim 1, wherein L₁ has a finer pore structure than L₂.

9. The method of claim 8, wherein for the S₁ simulation L₁ is simulated at a representative elementary volume (REV) while only a fraction of L₂ is captured.

10. The method of claim 1, further comprising the step of forming the physical PEMFC according to the first interface characterization and the second interface characterization.

11. A computer program comprising instructions, which when the program is executed by a computer, cause the computer to perform the method of any of claims 1 to 10.

12. A computer readable storage medium having recorded thereon a computer program of claim 11.

13. A system comprising a processor coupled to a memory, the memory having recorded thereon the computer program of claim 11.
